# EUROPEAN PATENT SPECIFICATION

(11) **EP 0 367 504 B1**
(45) Date of publication and mention of the grant of the patent: **11.08.1993**
(21) Application number: 89311075.9
(22) Date of filing: 26.10.1989
(51) Int. Cl.: C23C 22/68, C23C 22/83, C09J 5/02

(54) **Surface treatment of metals**
Oberflächenbehandlung von Metallen
Traitement superficiel de métaux

(30) Priority: 01.11.1988 GB 8825482
(43) Date of publication of application: 09.05.1990
(73) Proprietor: THE BRITISH PETROLEUM COMPANY P.L.C., London EC2M 7BA (GB)
(72) Inventor: Cayless, Richard Arthur, Sunbury-on-Thames Middlesex TW16 7LN (GB)
(74) Representative: Preece, Michael

(56) References cited:
- EP-A- 0 089 810
- EP-A- 0 331 284
- EP-A- 0 353 957
- DE-A- 2 334 342
- FR-A- 1 530 257
- FR-A- 2 183 582
- FR-A- 2 227 350
- US-A- 3 592 681
- US-A- 3 969 152
- PATENT ABSTRACTS OF JAPAN, vol. 10, no. 172 (C-354)(2228), June 18, 1986; & JP-A-61 23 766
- PATENT ABSTRACTS OF JAPAN, vol. 9, no. 52 (C-269)(1775), March 06, 1985; & JP-A-59 193 280
- MANUFACTURING TECHNOLOGY NOTE, U.S. ARMY MATERIEL DEVELOPMENT & READINESS COMMAND, report no. ARLCD-TR-78042, July 1980; filing code 94G-053; "Improved metal bonding with silanes"

## Description

This invention relates to a method of treating metal surfaces.

Organosilanes are known to be effective adhesion promoters for metal/polymer bonding. Such silanes are disclosed in "Silane Coupling Agents" by E.P. Pluddemann (Plenum Press, New York 1982).

Our copending application EP-A-0 331 284 describes a method of treatment of a metal oxide layer, the metal oxide layer being in contact with metal in the bulk state and being formed by exposure to oxygen of the metal in the bulk state. The process is characterised in that the metal oxide layer is treated with an aqueous solution of a salt of a metal selected from a group consisting of yttrium and metals of the lanthanum series having atomic numbers from 57 to 71 inclusive for a continuous period of less than one day, the metal oxide being subsequently subjected to a drying process. The application also describes the application of an adhesive to the treated layer. However there is no suggestion that the performance of any such adhesive bond will be improved by further treatments.

Our copending patent application EP-A-0 353 957 describes a process for the treatment of a metal oxide layer, the metal oxide layer being in contact with a metal in the bulk state and being formed by exposure to oxygen in the bulk state. The process comprises treating the metal oxide layer with an aqueous medium containing a chromium compound and alumina in which any chromium present in solution in the aqueous medium is released from alumina particles which have been previously prepared so as to have chromate anions releasably bound to the alumina. Again there is no suggestion in this specification that the performance of adhesive bonds resulting from application of adhesive to the treated layer can be improved by a further treatment.

We have now found that improved bonding of organic materials such as adhesives to metal surfaces can be obtained by a two stage treatment.

According to the present invention there is provided a process for treating a metal surface characterised in that it comprises the steps of:
(1) contacting the metal surface with an aqueous treatment medium which is:
   a) a solution of a salt of a metal selected from the group consisting of yttrium and metals of the lanthanum series having atomic numbers from 57 to 71 inclusive
      and
(2) subsequently contacting the metal surface with a solution of an organosilane.

It has been found that the use of organosilanes in conjunction with certain inorganic metal surface treatments gives surprising results in adhesion promotion. The organosilane can be chosen from a wide variety of such reagents. The organosilane will preferably contain an alkoxy group preferably ethoxy or methoxy. In particular it is preferred that the organosilane is an aminosilane or an epoxy silane. The amino silane is preferably 3-(2-amino ethyl amino) propyl trimethoxy silane. The epoxy silane is preferably 2-(3-glycidyloxy) propyl trimethoxy silane.

Where the metal surface is contacted with aqueous solutions of a salt of yttrium or of a lanthanide metal, the salt is preferably a salt of yttrium, samarium or cerium. The solutions referred to can either be solutions of salts of individual metals or they can be solutions of mixed metal salts. Mixed metal salts may be derived from natural ores where the occurrence of several metals is known. The counter anion is preferably the nitrate anion because of its relatively high solubility in water. The concentration of the applied metal salt solutions can be in the range 10⁻¹ - 10⁻⁶M, preferably 10⁻² - 10⁻⁶M, more preferably in the range 10⁻³ - 10⁻⁵M, for example in the range 5.0 x 10⁻³ - 5.0 x 10⁻⁴M.

Aqueous solutions of a salt of yttrium or of a lanthanide metal can be applied by any of the usual techniques used for applying reagent solutions to metal surfaces e.g. dipping, spraying, flooding etc.

The organosilane is preferably applied from a solution in a organic solvent, although water can be used. An example of an organic solvent is toluene. Concentration of the organosilane is preferably in the range 0.5 - 2% w/w.

The present invention is applicable to most metals, in particular steel, aluminium and zinc, preferably steel, more preferably cold rolled mild steel. The metal surface in the present invention may have undergone an initial cleaning step, for the purposes, for example, of removing temporary protective materials such as oil. This cleaning may be by chemical means (alkaline wash) by mechanical means (abrading)or a solvent wash may be used; such methods are well known in the art. Furthermore, the metal may be subsequently stored after treatment so that it may be used at a later date. For example, steel may be covered in a protective oil to prevent corrosion. The treatment of the present invention is storage resistant and the adhesion promotion effect is not adversely affected by such storage methods.

The treatment of metal surfaces in consecutive steps comprising treatment with an inorganic metal surface reagent followed by treatment with a solution of an organosilane is suitably used in conjunction with polymeric organic adhesives. Examples of such adhesives are epoxy resins, acrylic resins, polyurethane resins, vinyl resins, and phenolic resins, preferably epoxy resins. The organosilane can be applied prior to application of the adhesive, or alternatively it can be added to the adhesive formulation itself which can be then applied as a solution in the adhesive after the metal surface has been contacted with a) an aqueous solution of yttrium or of a lanthanide metal.

The invention may be used to increase adhesive bond strengths and to enhance the durability of adhesive bonds, particularly in aqueous environments. A typical structure using the present invention would comprise two metal objects treated according to the invention and bonded together using an adhesive. The metal objects may be different parts of the same structure. Thus the two ends of a metal sheet may be bonded together to form a tube.

The adhesion of an organic polymer surface coating to a metal surface can also be enhanced by treatment of the metal surface according to the present invention. The invention is now illustrated with reference to the following examples.

### Adhesion Test Method

Mild steel test pieces (pretreated as described below) were bonded with epoxy adhesive to determine the adhesive properties of treated and untreated steel. The test pieces measured 2.54 cm by 6.35cm and were cut from 0.75 mm steel paint test panels supplied by the Pyrene Chemical Services Ltd. This is grade CR1 cold rolled steel polished on one side only and supplied coated with a protective oil to prevent rusting. The adhesive was a simple commercially available epoxy resin; Shell Epikote 828 cured with DMP30 hardener (Anchor Chemical Company). 10 parts adhesive were mixed with one part of hardener (by weight) immediately prior to use. The steel was cleaned in an ultrasonic solvent degreasing bath (1,1,1-trichloroethylene) to remove the protective oil prior to any treatment. 2.54 cm square lap bonds were prepared by bonding the ends of the polished sides of two test pieces together with a 2.54 cm overlap. Bond line thickness was aproximately 1 mm. The adhesive was then cured at 80°C for 1 hour.

A total of 8 such samples were prepared for each treatment. Of these, four were subjected to a durability test (400 hours immersion in distilled water at 50°C) to determine the effect of hot wet environments on joint strength. The bond strength of the joints was determined using an Instron materials testing machine in which samples are pulled apart at constant speed and the load required to cause failure is recorded. The bonded samples are 10.16 cm long (2x6.35 cm - 2.54 cm overlap), of this 1.27 cm at each end is used by the test machine grips to hold the sample. The samples were pulled apart at 0.5mm/minute under ambient conditions. The durability (water immersion) samples were tested immediately after removal from the water.

The results of the adhesion test are recorded as average failure strengths in Table I. The percentage loss of adhesion on water immersion is also given.

Test pieces were treated according to the invention as indicated below; these pieces were then tested according to the above method. Comparative tests were carried out as described. Results are given in Table I.

### Comparative Test A (not according to the invention)

Test pieces were tested according to the method described above, the test pieces receiving no pretreatment other than described in the method.

### Comparative Test B (not according to the invention)

Test pieces were immersed in a 10⁻⁴ molar solution of yttrium nitrate in distilled water for 5 minutes, they were then rinsed twice using distilled water and dried on a tissue. The test pieces were then tested according to the method described above.

Pure compounds such as yttrium nitrate are relatively costly. Commercially available mixtures of rare earth nitrates which are much cheaper can also be used in treating test pieces (see Comparative Test C).

### Comparative Test C (not according to the invention)

Treatment of test pieces was carried out according to the method described in Comparative Test C but using commercially available mixed rare earth metal nitrates. The test pieces were then tested according to the test described above.

### Comparative Test D (not acccording to the invention)

Test pieces were immersed in a 1% w/w solution of the aminosilane (CH₃O)₃ Si (CH₂)₃NH(CH₂)₂NH₂ then washed 3 times for 1 minute in toluene. The plates were allowed to dry, excess toluene being removed with a tissue, bonded and tested as described above.

### Example 1 (according to the invention)

Test pieces were treated as described in Comparative Test B, then treated with aminosilane as described in Comparative Test D. The test pieces were bonded and tested as described above.

### Example 2 (according to the invention)

Test pieces were treated as described in Comparative Test C, then treated with aminosilane as described in comparative Test D. The test pieces were bonded and tested as described above.

### Comparative Test E (not according to the invention)

Test pieces were treated as described in Comparative Test A. The test pieces were bonded and tested as discussed above except that 1% by weight of the aminosilane (CH₃O)Si(CH₂)₃NH(CH₂)₂NH₂ was added to the epoxy adhesive prior to bonding.

Results of all the testing according to the method described above for Comparative Tests A-E and Examples 1-2 are given in Table I.

The yttrium nitrate was supplied by BDH. The rare earth metal nitrate was supplied by Rare Earth Products (Widnes, Cheshire) as a solution of the metal oxides neutralised with nitric acid and subsequently diluted as needed.

The aminosilane was supplied by Fluka.

Alcoa, Epikote and Instron are all Trade Marks.

**TABLE I**

| TEST EXAMPLE | TREATMENT | INITIAL STRENGTH | 400HR STRENGTH | % LOSS |
|---|---|---|---|---|
| A | Untreated | 3.33 | 2.45 | 26 |
| B | Y(NO₃)₃ No aminosilane | 3.39 | 2.86 | 16 |
| C | Mixed rare earth metal nitrates. | 3.53 | 3.04 | 14 |
| | No aminosilane | | | |
| D | Aminosilane | 4.01 | 3.01 | 25 |
| 1 | Y(NO₃)₃/aminosilane | 4.33 | 3.78 | 12.7 |
| 2 | Mixed rare earths/aminosilane | 4.42 | 4.05 | 8.4 |
| E | Aminosilane in adhesive | 3.79 | 3.01 | 21 |

## Claims

1. A process for treating a metal surface characterised in that it comprises the steps of:
(1) contacting the metal surface with an aqueous treatment medium which is:
a) a solution of a salt of a metal selected from the group consisting of yttrium and metals of the lanthanum series having atomic numbers from 57 to 71 inclusive,
and
(2) subsequently contacting the metal surface with a solution of organosilane.

2. A process according to claim 1 wherein the metal surface is treated with an aqueous solution of yttrium, samarium or cerium.

3. A process according to either of claims 1 or 2 wherein the metal surface is treated with an aqueous solution of a nitrate salt of a metal selected from the group consisting of yttrium and metals of the lanthanum series having atomic numbers from 57 to 71 inclusive.

4. A process according to any one of the preceding claims wherein the concentration of the salt of the metal selected from the group consisting of yttrium and metals of the lanthanum series is in the range 10⁻¹ - 10⁻⁶M.

5. A process according to any one of the preceding claims wherein the organosilane contains an alkoxy group.

6. A process according to claim 5 wherein the alkoxy group is ethoxy or methoxy.

7. A process according to any one of the preceding claims wherein the organosilane is an aminosilane or an epoxy silane.

8. A process according to any one of the preceding claims which comprises applying a layer of an organic polymer surface coating subsequently to or simultaneously with the step of contacting the metal surface with an organo-silane.

9. A structure comprising two metal objects having treated surfaces which have
(1) been treated by being contacted with an aqueous treatment medium which is:
a) a solution of a salt of a metal selected from the group consisting of yttrium and metals of the lanthanum series having atomic numbers from 57 to 71 inclusive,
and
(2) subsequently been contacted with a solution of an organo silane, and
(3) bonded together by a layer of a polymeric organic adhesive.

## Patentansprüche

1. Verfahren zur Behandlung einer Metall-Oberfläche, dadurch gekennzeichnet, daß es die Schritte
(1) des In-Berührung-Bringens der Metall-Oberfläche mit einem wäßrigen Behandlungsmedium, das
(a) eine Lösung eines Salzes eines Metalls ist, das aus der aus Yttrium und Metallen der Lanthan-Reihe mit Atom-Zahlen von 57 bis einschließlich 71 ausgewählt ist, und
(2) des anschließenden In-Berührung-Bringens der Metall-Oberfläche mit einer Organosilan-Lösung
umfaßt.

2. Verfahren nach Anspruch 1, worin die Metall-Oberfläche mit einer wäßrigen Lösung von Yttrium, Samarium oder Cer behandelt wird.

3. Verfahren nach Anspruch 1 oder Anspruch 2, worin die Metall-Oberfläche mit einer wäßrigen Lösung eines Nitrat-Salzes eines Metalls behandelt wird, das aus der aus Yttrium und Metallen der Lanthan-Reihe mit Atom-Zahlen von 57 bis einschließlich 71 ausgewählt ist.

4. Verfahren nach irgendeinem der vorhergehenden Ansprüche, worin die Konzentration des Salzes des Metalls, das aus der aus Yttrium und Metallen der Lanthan-Reihe ausgewählt ist, im Bereich von 10⁻¹ bis 10⁻⁶ M liegt.

5. Verfahren nach irgendeinem der vorhergehenden Ansprüche, worin das Organosilan eine Alkoxy-Gruppe enthält.

6. Verfahren nach Anspruch 5, worin die Alkoxy-Gruppe Ethoxy oder Methoxy ist.

7. Verfahren nach irgendeinem der vorhergehenden Ansprüche, worin das Organosilan ein Aminosilan oder ein Epoxy-Silan ist.

8. Verfahren nach irgendeinem der vorhergehenden Ansprüche, umfassend das Aufbringen einer Schicht einer organischen Polymer-Oberflächenbeschichtung anschließend an den Schritt oder simultan mit dem Schritt des In-Berührung-Bringens der Metall-Oberfläche mit einem Organosilan.

9. Struktur, umfassend zwei Metall-Gegenstände mit behandelten Oberflächen, die
(1) dadurch behandelt worden sind, daß sie mit einem wäßrigen Behandlungsmedium in Berührung gebracht wurden, das
(a) eine Lösung eines Salzes eines Metalls ist, das aus der aus Yttrium und Metallen der Lanthan-Reihe mit Atom-Zahlen von 57 bis einschließlich 71 ausgewählt ist,
(2) anschließend mit einer Lösung eines Organosilans in Berührung gebracht wurden und
(3) durch eine Schicht eines polymeren organischen Klebstoffs miteinander verbunden wurden.

## Revendications

1. Procédé de traitement d'une surface métallique, caractérisé en ce qu'il comprend les étapes :
(1) de mise en contact de la surface métallique avec un milieu aqueux de traitement qui est :
(a) une solution d'un sel d'un métal choisi dans le groupe consistant en l'yttrium et les métaux de la série du lanthane ayant les numéros atomiques de 57 à 71 inclus,
(2) de mise en contact ultérieure de la surface métallique avec une solution d'un organosilane.

2. Procédé suivant la revendication 1, dans lequel la surface métallique est traitée avec une solution aqueuse d'yttrium, de samarium ou de cérium.

3. Procédé suivant la revendication 1 ou 2, dans lequel la surface métallique est traitée avec une solution aqueuse d'un nitrate d'un métal choisi dans le groupe consistant en l'yttrium et les métaux de la série du lanthane ayant les numéros atomiques de 57 à 71 inclus.

4. Procédé suivant l'une quelconque des revendications précédentes, dans lequel la concentration du sel du métal choisi dans le groupe consistant en l'yttrium et les métaux de la série du lanthane est comprise dans l'intervalle de 10⁻¹ à 10⁻⁶M.

5. Procédé suivant l'une quelconque des revendications précédentes, dans lequel l'organosilane contient un groupe alkoxy.

6. Procédé suivant la revendication 5, dans lequel le groupe alkoxy est un groupe éthoxy ou méthoxy.

7. Procédé suivant l'une quelconque des revendications précédentes, dans lequel l'organosilane est un aminosilane ou un époxysilane.

8. Procédé suivant l'une quelconque des revendications précédentes, qui comprend l'application d'une couche d'un revêtement polymérique organique de surface après, ou bien simultanément avec, l'étape de mise en contact de la surface métallique avec un organosilane.

9. Structure comprenant deux objets métalliques à surfaces traitées qui ont
(1) été traitées par mise en contact avec un milieu aqueux de traitement qui est :
(a) une solution d'un sel d'un métal choisi dans le groupe consistant en l'yttrium et les métaux de la série du lanthane ayant les numéros atomiques de 57 à 71 inclus, et
(2) ont été ensuite mises en contact avec une solution d'un organosilane, et
(3) liées ensemble par une couche d'un adhésif organique polymérique.
